# EUROPEAN PATENT APPLICATION

(11) **EP 2 367 209 A2**
(43) Date of publication of application: **21.09.2011**
(21) Application number: 10195103.6
(22) Date of filing: 15.12.2010
(51) Int. Cl.: H01L 33/00

(54) **Method for manufacturing semiconductor light emitting device**

(30) Priority: 18.03.2010 JP 2010063288
(71) Applicant: Kabushiki Kaisha Toshiba, Minato-ku Tokyo (JP)
(72) Inventor: Akaike, Yasuhiko, Minato-ku, Tokyo (JP); Nishiwaki, Wakana, Minato-ku, Tokyo (JP)
(74) Representative: HOFFMANN EITLE

(57) **Abstract**

A method for manufacturing a semiconductor light emitting device characterized by bonding a first stacked body (20) to a second stacked body (40) is disclosed. The first stacked body includes a first substrate (10), a semiconductor layer (12), and a first metal layer (15). The second stacked body includes a second substrate (30) and a second metal layer (35). The method includes overlaying the first metal layer and the second metal layer by shifting a cleavage direction of the first stacked body from a cleavage direction of the second stacked body. The method includes bonding the first stacked body and the second stacked body by increasing a temperature in a state of pressing the first stacked body and the second stacked body into contact.

## Description

### FIELD

Embodiments described herein relate generally to a method for manufacturing a semiconductor light emitting device.

### BACKGROUND

Manufacturing methods in which a semiconductor layer including a light emitting layer is separated from a growth substrate and transferred onto another substrate have been used for semiconductor light emitting devices such as light emitting diodes (LEDs). For example, JP-A 2005-303287 (Kokai) discusses increasing the productivity of a Group III nitride semiconductor light emitting device by separating a Group III nitride semiconductor layer from a growth substrate.

However, there are cases in which breakage and cracks of the substrate occur when the semiconductor layer is transferred onto the different substrate. Therefore, there is a need for a manufacturing method that can prevent breakage and cracks of the substrate.

### BRIEF DESCRIPTION OF THE DRAWINGS

FIGS. 1A to 1D are cross-sectional views of processes schematically illustrating a method for manufacturing a semiconductor light emitting device according to an embodiment;
FIG. 2 is a schematic view describing a substrate bonding process performed in the manufacturing process of the semiconductor light emitting device according to the embodiment;
FIGS. 3A and 3B are schematic views describing operations and effects of the method for manufacturing the semiconductor device according to the embodiment;
FIGS. 4A and 4B are schematic views illustrating the manufacturing processes of the semiconductor light emitting device continuing from FIG. 1D; and
FIG. 5 is a perspective view schematically illustrating the method for manufacturing the semiconductor light emitting device according to another embodiment.

### DETAILED DESCRIPTION

In one embodiment, a method for manufacturing a semiconductor light emitting device characterized by bonding a first stacked body to a second stacked body is disclosed. The first stacked body includes a first substrate, a semiconductor layer, and a first metal layer. The second stacked body includes a second substrate and a second metal layer. The method can include overlaying the first metal layer and the second metal layer by shifting a cleavage direction of the first stacked body from a cleavage direction of the second stacked body and by bringing the first metal layer and the second metal layer into contact. The method can include bonding the first stacked body and the second stacked body by increasing a temperature in a state of pressing the first stacked body and the second stacked body into contact.

Embodiments of the invention will now be described with reference to the drawings. In the embodiments hereinbelow, similar portions in the drawings are marked with like numerals and a detailed description thereof is omitted as appropriate; and different portions are described as appropriate.

A method for manufacturing a semiconductor light emitting device according to one embodiment of the invention includes a process of overlaying a first stacked body including a first metal layer provided on a first substrate with a second stacked body including a second metal layer provided on a second substrate by shifting a cleavage direction of the first substrate from a cleavage direction of the second substrate and by bringing the first metal layer and the second metal layer into contact. The first stacked body includes a semiconductor layer on the first substrate, where the semiconductor layer includes a light emitting layer that radiates light; and the first metal layer is provided on the semiconductor layer.

The method further includes a process of bonding the first stacked body and the second stacked body by increasing a temperature in a state of pressing the first stacked body and the second stacked body into contact.

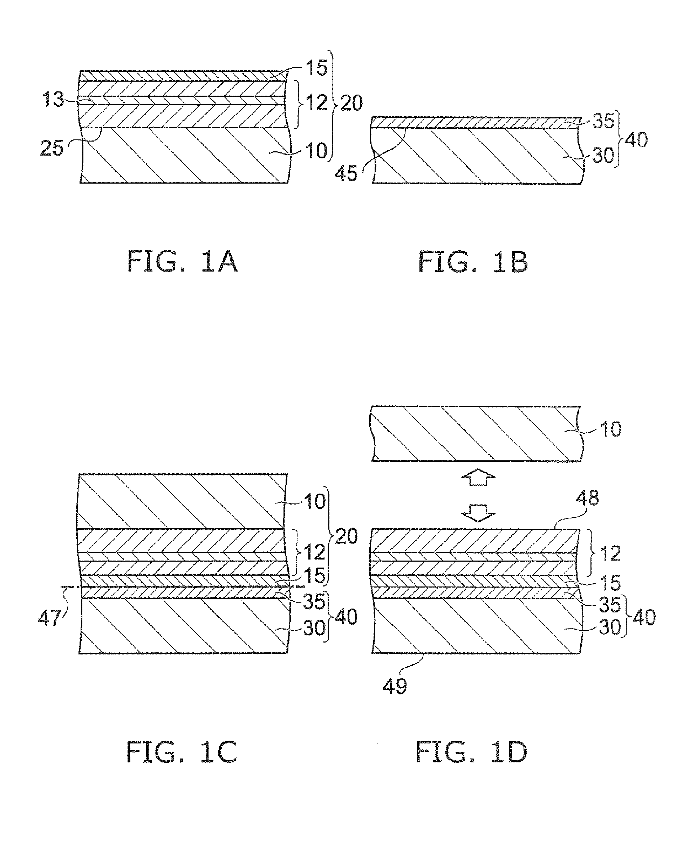

FIGS. 1A to 1D are cross-sectional views of processes schematically illustrating the method for manufacturing the semiconductor light emitting device according to the one embodiment of the invention. In the description of the manufacturing method according to this embodiment, for example, the first substrate is taken to be an n-type GaAs substrate 10 and the second substrate is taken to be a p-type silicon (Si) substrate 30. A semiconductor layer 12 provided on the n-type GaAs substrate 10 includes, for example, an InGaAlP semiconductor.

FIG. 1A illustrates a cross section of a first stacked body 20 in which the semiconductor layer 12 is provided. FIG. 1B illustrates a cross section of a second stacked body 40. FIG. 1C is a cross-sectional view illustrating the state of the second stacked body 40 overlaid on the first stacked body 20. FIG. 1D is a cross-sectional view illustrating the state in which the semiconductor layer 12 remains on the second stacked body 40 and the n-type GaAs substrate 10 is removed.

As illustrated in FIG. 1A, the first stacked body 20 includes the n-type GaAs substrate 10, the semiconductor layer 12 and a first metal layer 15. The semiconductor layer 12 is formed by using, for example, MOCVD (Metal Organic Chemical Vapor Deposition) or MBE (Molecular Beam Epitaxy), or the like.

On the other hand, as illustrated in FIG. 1B, the second stacked body 40 includes the p-type Si substrate 30 and a second metal layer 35 formed by using vacuum vapor deposition.

In the case where a light emitting layer 13 included in the semiconductor layer 12 is an IrtGaAlP semiconductor, the semiconductor light emitting device can emit visible light in a wavelength range of yellowish-green to red. A good crystal can be provided easily because the semiconductor layer 12 is made of an InGaAlP compound crystal and has lattice matching with GaAs.

Then, as illustrated in FIG. 1C, the first stacked body 20 is overlaid on the second stacked body 40; and the first metal layer 15 and the second metal layer 35 are brought into contact at a bonding interface 47. Then, a prescribed substrate bonding process is implemented to bond the first stacked body 20 and the second stacked body 40. At this time, the first stacked body 20 and the second stacked body 40 are bonded with a cleavage direction of the first stacked body 20 shifted from a cleavage direction of the second stacked body 40.

For example, the cleavage direction of the first stacked body 20 matches the cleavage direction of the n-type GaAs substrate 10; and the cleavage direction of the second stacked body 40 matches the cleavage direction of the p-type Si substrate 30. Accordingly, in the case where a major surface 25 of the n-type GaAs substrate 10 is a (100) surface and a major surface 45 of the p-type Si substrate 30 is a (100) surface, the first stacked body 20 and the second stacked body 40 are bonded with the <110> direction of the n-type GaAs substrate 10 shifted from the <110> direction of the p-type Si substrate 30.

The first metal layer 15 or the second metal layer 35 may include, for example, gold (Au) and metals including Au such as AuIn, AuSn, etc. The bonding strength between Au and Au may be increased by the first metal layer 15 and the second metal layer 35 having a multilayered structure of Ti/Pt/Au. A solder alloy of InSn and the like also may be used. The first metal layer 15 or the second metal layer 35 may include tungsten (W) as a barrier metal. The first metal layer and the second metal layer also may be, for example, copper (Cu) or aluminum (Al).

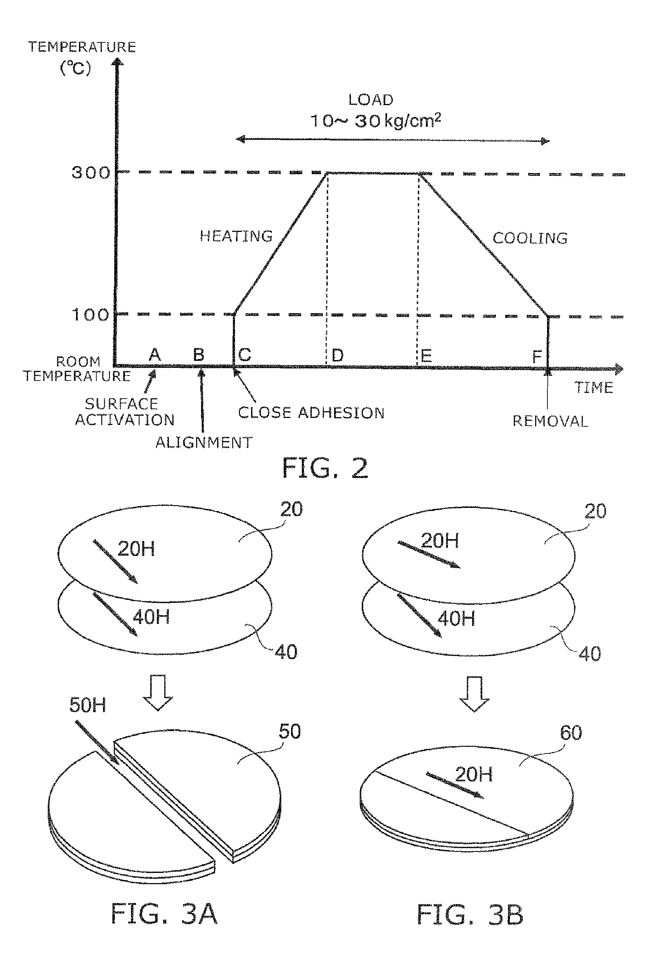

An example of the substrate bonding process will now be described with reference to FIG. 2.

In the substrate bonding process according to this embodiment, for example, the first stacked body 20 and the second stacked body 40 are heated and bonded after being overlaid in a vacuum. FIG. 2 schematically illustrates the temporal change of the processing temperature of such a process.

First, the first stacked body 20 and the second stacked body 40 are placed in the interior of a not-illustrated vacuum container; and the interior of the vacuum container is brought to a low-pressure state.

Then, for example, surface activation may be performed prior to overlaying the first stacked body 20 and the second stacked body 40. (Surface activation A)

Specifically, unnecessary oxide films, organic substances, and the like are removed from the surface of the first metal layer and the surface of the second metal layer 35 by, for example, irradiating an argon (Ar) ion beam. Also, the surface of the first metal layer 15 and the surface of the second metal layer 35 may be exposed to a plasma atmosphere.

Also, the first stacked body 20 and the second stacked body 40 may be overlaid without performing the surface activation.

Continuing, the surface of the first metal layer 15 and the surface of the second metal layer 35 are brought into contact; and the first stacked body 20 and the second stacked body 40 are overlaid. (Alignment B)

Specifically, the surface of the first metal layer 15 and the surface of the second metal layer 35 are disposed opposing each other; and the cleavage directions of the n-type GaAs substrate 10 and the p-type Si substrate 30 are matched. Further, either of the substrates is rotated to shift the angle between the cleavage directions thereof to a prescribed angle. Then, the first metal layer 15 and the second metal layer 35 are brought into contact to overlay the first stacked body 20 and the second stacked body 40.

Then, a pressing load is applied between the first stacked body 20 and the second stacked body 40 to closely adhere the first stacked body 20 and the second stacked body 40 to each other. (Close adhesion C)

It is desirable for the temperature at which the first stacked body 20 and the second stacked body 40 are closely adhered to be not more than 100 °C. Thereby, it is possible to reduce the warp occurring due to differences in the coefficient of thermal expansion between the n-type GaAs substrate 10 and the p-type Si substrate 30, for example, when returning the bonded substrates to room temperature.

The load applied between the first stacked body 20 and the second stacked body 40 may be not less than 10 kg/cm² and not more than 30 kg/cm². It is desirable to apply, for example, a pressing load not less than 10 kg/cm² to provide a state in which the surface of the first metal layer 15 and the surface of the second metal layer 35 are entirely and closely adhered. Further, it is desirable for the load to be not more than 30 kg/cm² so that breakage and cracks of the first stacked body 20 and the second stacked body 40 do not occur.

The maximum load of, for example, about 20 kg/cm² can be applied between the n-type GaAs substrate 10 and the p-type Si substrate 30 when overlaid with matched cleavage directions. On the other hand, it is possible to apply a pressing load of up to 30 kg/cm² by overlaying with a shifted angle between the two cleavage directions of not less than 1°.

Continuing, the first stacked body 20 and the second stacked body 40 are heated in the overlaid state while the load is applied; and the temperature is increased to a prescribed temperature (C to D).

For example, in the case where the first metal layer 15 and the second metal layer 35 are metals including Au, the first metal layer 15 and the second metal layer 35 are heated to a temperature not less than 250 °C. This is because it is desirable to increase the temperature to not less than 250 °C to bond the first stacked body 20 and the second stacked body 40 such that defects such as voids and the like do not occur between the first metal layer 15 and the second metal layer 35.

On the other hand, it is desirable to maintain the temperature at not more than 350 °C so that breakage and cracks do not occur in the first stacked body 20 and the second stacked body 40 due to stress caused by differences in the coefficient of thermal expansion between the n-type GaAs substrate 10 and the p-type Si substrate 30.

Continuing, after maintaining the first stacked body 20 and the second stacked body 40 in the overlaid state for a constant time at the prescribed temperature, the first stacked body 20 and the second stacked body 40 are cooled to a temperature of 100 °C or less and removed from the vacuum container. (D to E to removal F)

During this interval, the overlaid first stacked body 20 and second stacked body 40 are maintained in the state of the applied prescribed load until the temperature is reduced to 100 °C or less.

By irradiating, for example, the surface of the first metal layer 15 and the surface of the second metal layer 35 with an Ar ion beam in the substrate bonding process recited above, active bonds of the atoms can be exposed in the metal surface. Thereby, it is possible to reduce the energy necessary to bond the metal atoms of the surface of the first metal layer 15 to the surface of the second metal layer 35. In other words, the bonding is possible at a lower temperature than in the case where the Ar ion beam is not irradiated. For example, there are cases where bonding of the substrates is possible at room temperature when the bonding process is performed in an ultra-high vacuum state after the surface activation.

Continuing as illustrated in FIG. 1D, the n-type GaAs substrate 10 is removed from the first stacked body 20 bonded to the second stacked body 40 by using at least one selected from mechanical polishing and solution-based etching. In such a case, the n-type GaAs substrate 10 may be completely removed; or a portion thereof may remain.

Then, the semiconductor light emitting device is completed by forming an n-electrode on a front face 48 of the semiconductor layer 12 from which the n-type GaAs substrate 10 is removed and by forming a p-electrode on a back face 49 of the p-type Si substrate 30.

As another embodiment, the first substrate may be a sapphire substrate; and the semiconductor layer may be formed using a nitride semiconductor. For example, the first stacked body including a semiconductor layer, in which an n-type GaN layer/light emitting layer/p-type GaN layer are stacked, may be provided by MOCVD on the sapphire substrate. The light emitting layer may include a MQW (Multi-Quantum Well) layer in which an InₓGa₁₋ₓN layer (0 < *x* < 1) and an Al_{y}Ga_{1-y}N layer (0 ≤ *y* < 1) are alternately stacked.

In the process of removing the first substrate illustrated in FIG. 1D, for example, laser lift-off may be used in which laser light having a wavelength of 355 nm is irradiated from the sapphire substrate side; the GaN is decomposed in a portion proximal to the interface between the sapphire substrate and the n-type GaN layer; and the sapphire substrate is peeled.

Operations and effects of the method for manufacturing the semiconductor light emitting device according to this embodiment will now be described with reference to FIGS. 3A and 3B. FIG. 3A is a schematic view illustrating the effects of a manufacturing method according to a comparative example; and FIG. 3B is a schematic view illustrating the operations and effects of the manufacturing method according to this embodiment.

In the manufacturing method according to the comparative example illustrated in FIG. 3A, the first stacked body 20 and the second stacked body 40 are bonded with cleavage directions 20H and 40H thereof matched to form a bonded substrate 50. The first stacked body 20 and the second stacked body 40 have the property of being easily broken along the cleavage directions thereof when stress is applied. Accordingly, in the case where the cleavage direction 20H of the first stacked body 20 is matched to the cleavage direction 40H of the second stacked body 40 as in the comparative example, the bonded substrate 50 is easily broken along a cleavage direction 50H common to the cleavage direction 20H and the cleavage direction 40H as illustrated in FIG. 3A.

The property recited above is advantageous when subdividing the semiconductor devices constructed using the bonded substrate 50 into individual chips. For example, in the case where the first stacked body 20 is formed using a GaAs (100) substrate and the second stacked body 40 is formed using a Si (100) substrate, the cleavage direction of both is the <110> direction; and the (011) surface and the (101) surface have cleaving properties. Accordingly, the bonded substrate 50 bonded with the two matched cleavage directions has the advantage that rectangular semiconductor device chips can be cut out easily because the bonded substrate 50 has orthogonal cleaving surfaces of the (011) surface and the (101) surface. Therefore, when bonding two substrates, manufacturing methods are often used, where the two cleavage directions match each other.

However, matching the cleavage directions of two substrates to have a common cleaving surface means that the bonded substrates are easily broken. Specifically, in the substrate bonding process described above, there is a high possibility that both the first stacked body 20 and the second stacked body 40 may break due to stress occurring between the first stacked body 20 and the second stacked body 40 due to heating, locally concentrated stress due to protrusions and the like existing at the bonding interface 47, etc.

Conversely, in the manufacturing method according to this embodiment as illustrated in FIG. 3B, a substrate 60 is formed by bonding in which the cleavage direction 20H of the first stacked body 20 and the cleavage direction 40H of the second stacked body 40 are shifted. By bonding with shifted cleavage directions, even in the case where breakage and cracks occur in one of the substrates, the stress thereof is not transmitted directly to the cleavage direction of the other substrate. Accordingly, the strength of the bonded substrate 60 can be higher than that of the bonded substrate 50 illustrated in FIG. 3A.

Thereby, it is possible to suppress the breakage and cracks occurring in the substrate bonding; and the manufacturing yields can be increased. Specifically, it is desirable for the shift between the cleavage direction 20H of the first stacked body 20 and the cleavage direction 40H of the second stacked body 40 to be not less than 1°.

For example, the p-type Si substrate 30 of the second stacked body 40 is stronger than the n-type GaAs substrate 10 of the first stacked body 20; and the first stacked body 20 breaks more easily than the second stacked body 40. Accordingly, in the bonded substrate 60 as illustrated in FIG. 3B, the second stacked body 40 can support and maintain the fixed form even in the case where the first stacked body 20 breaks along the cleavage direction 20H. Thereby, it is possible to implement subsequent processing to construct the semiconductor light emitting device.

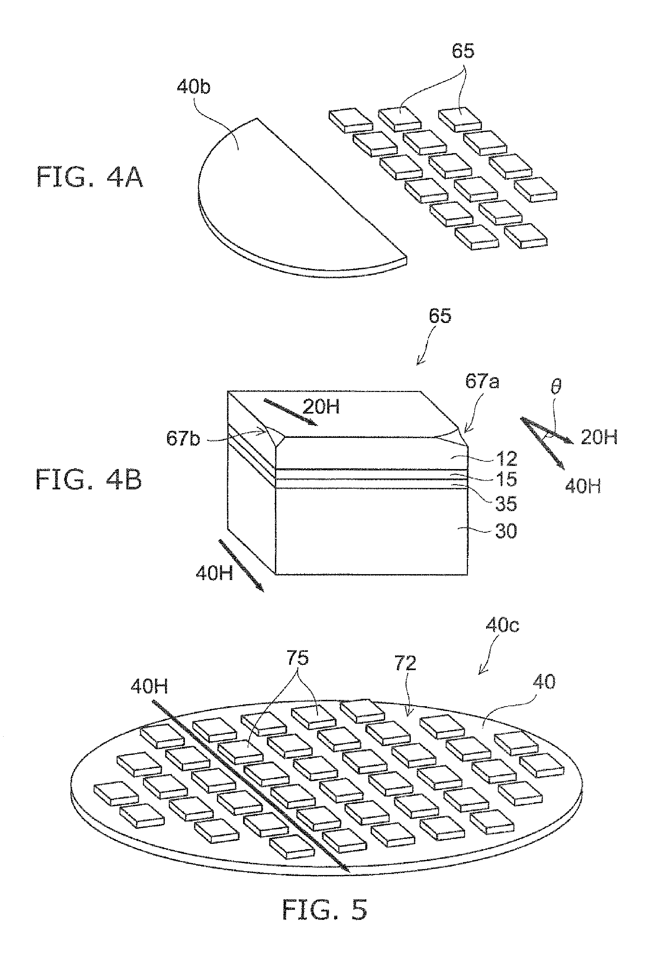

FIGS. 4A and 4B are schematic views illustrating the manufacturing processes of the semiconductor light emitting device continuing from FIG. 1D.

In a semiconductor substrate 40b illustrated in FIG. 4A, the n-type GaAs substrate 10 has been removed from the bonded substrate 60 in the process illustrated in FIG. 1D, and the semiconductor layer 12 is transferred onto the second stacked body 40. As described above, an n-electrode is provided on the front face 48 of the semiconductor layer 12 of the semiconductor substrate 40b; a p-electrode is provided on the back face 49 on the p-type Si substrate 30 side; and the semiconductor light emitting device is completed.

Continuing as illustrated in FIG. 4A, the semiconductor substrate 40b is subdivided into individual light emitting device chips 65 by cutting using, for example, a dicing blade.

FIG. 4B schematically illustrates the structure of the light emitting device chip 65. The cleavage direction of the semiconductor layer 12 provided on the n-type GaAs substrate 10 is the same direction as the cleavage direction 20H of the n-type GaAs substrate 10. Accordingly, for example, if the cutting direction of the dicing blade is matched to the cleavage direction 40H of the p-type Si substrate 30, the semiconductor layer 12 transferred onto the p-type Si substrate 30 is cut in a direction different from the cleavage direction 20H thereof.

In the case where a shifted angle θ is large between the cleavage direction 40H of the p-type Si substrate 30 and the cleavage direction 20H of the semiconductor layer 12, there are cases where chipping 67a and 67b such as that illustrated in FIG. 4B occurs in the cutting of the semiconductor substrate 40b with the dicing blade. This occurs because the semiconductor layer 12 breaks along the cleavage direction 20H due to the stress applied by the dicing blade. For example, chipping occurs easily in the case where the shifted angle θ of the cleavage direction is greater than 10°.

As described above, it is desirable for the shifted angle θ of the cleavage direction to be not less than 1° to increase the strength of the bonded substrates. Accordingly, it is desirable for the shifted angle θ between the cleavage direction of the first stacked body 20 and the cleavage direction of the second stacked body 40 to be not less than 1° and not more than 10° in the state in which the first stacked body 20 and the second stacked body 40 are overlaid.

FIG. 5 is a perspective view schematically illustrating the method for manufacturing the semiconductor light emitting device according to another mode of implementation.

The method for manufacturing the semiconductor light emitting device according to this embodiment further includes: a process of separating the first substrate while leaving the semiconductor layer on the second stacked body; a process of providing a dicing groove along the cleavage direction of the second stacked body to separate the semiconductor layer into individual semiconductor devices; and a process of cutting the second stacked body along the dicing groove.

Similarly to the semiconductor substrate 40b described above, the semiconductor layer 12 is transferred onto the second stacked body 40 in a semiconductor substrate 40c illustrated in FIG. 5. Further, the semiconductor layer 12 is separated into individual light emitting devices 75 by a dicing groove 72 provided in the direction along the cleavage direction 40H of the second stacked body 40.

The dicing groove 72 can be made by, for example, RIE (Reactive Ion Etching) using an etching gas including chlorine (Cl₂) or fluorine (F). Wet etching also can be used.

By the manufacturing method according to this embodiment, the individual light emitting devices 75 can be subdivided along the dicing groove 72 into chips. At this time, the cutting is easy because the dicing groove 72 and the cleavage direction 40H are matched to each other. Moreover, because the semiconductor layer 12 is separated by the dicing groove 72, there is no contact with the dicing blade when subdividing and, for example, the chipping 67a and 67b does not occur.

In other words, according to this embodiment, the shifted angle θ between the cleavage direction 20H of the first stacked body 20 and the cleavage direction 40H of the second stacked body 40 can be greater than 10°. Thereby, the strength of the bonded substrate 60 can be increased further.

In this embodiment as well, the first metal layer or the second metal layer may include, for example, Au or Au alloy. The first stacked body and the second stacked body are overlaid at a temperature not more than 100 °C. The substrate bonding process heats the first stacked body and the second stacked body to a temperature range of not less than 250 °C and not more than 350 °C and further includes a cooling process; and the pressing load applied between the first stacked body and the second stacked body can be not less than 10 kg/cm² and not more than 30 kg/cm².

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A method for manufacturing a semiconductor light emitting device **characterized by** bonding a first stacked body (20) to a second stacked body (40), the first stacked body (20) including a first substrate (10), a semiconductor layer (12), and a first metal layer (15), the second stacked body (40) including a second substrate (30) and a second metal layer (35), the method comprising:
overlaying the first metal layer (15) and the second metal layer (35) by shifting a cleavage direction of the first stacked body (20) from a cleavage direction of the second stacked body (40); and
bonding the first stacked body (20) and the second stacked body (40) by increasing a temperature in a state of pressing the first stacked body (20) and the second stacked body (40) into contact.

2. The method according to claim 1, further comprising:
separating the first substrate (10) while leaving the semiconductor layer (12) on the second substrate side;
providing a dicing groove (72) along the cleavage direction of the second substrate (30) to separate the semiconductor layer into individual semiconductor devices (65); and
cutting the second substrate (30) along the dicing groove (72).

3. The method according to claim 1 or 2, wherein the temperature of the first stacked body (20) and the second stacked body (40) is increased to not less than 250 °C and not more than 350 °C in the state of the first stacked body (20) and the second stacked body (40) being overlaid.

4. The method according to any of claims 1-3, wherein the overlaying of the first stacked body (20) and the second stacked body (40) is performed at a temperature not more than 100 °C.

5. The method according to any of claims 1-4, wherein at least one selected from the first metal layer (15) and the second metal layer (35) includes gold (Au).

6. The method according to any of claims 1-5, wherein the pressing load applied between the first stacked body (20) and the second stacked body (40) is not less than 10 kg/cm² and not more than 30 kg/cm².

7. The method according to any of claims 1-6, comprising irradiating an ion beam onto surfaces of the first metal layer (15) and the second metal layer (40) prior to the overlaying of the first stacked body (20) and the second stacked body (40).

8. The method according to any of claims 1-7, wherein the second substrate (30) is a silicon substrate.

9. The method according to any of claims 1-8, wherein the first substrate (10) is a GaAs substrate.

10. The method according to any of claims 1-8, wherein the first substrate (10) is a sapphire substrate.

11. The method according to any of claims 1-9, wherein major surfaces of the first substrate and the second substrate are (100) surfaces.

12. The method according to claim 11, wherein a shifted angle between the cleavage direction of the first substrate (10) and the cleavage direction of the second substrate (30) in the state of the first substrate (10) and the second substrate (30) being overlaid is not less than 1° and not more than 10°.
